(19) Europäisches Patentamt / European Patent Office / Office européen des brevets

(11) **EP 3 896 463 B1**

(12) **EUROPÄISCHE PATENTSCHRIFT**

(45) Veröffentlichungstag und Bekanntmachung des Hinweises auf die Patenterteilung:
**05.10.2022 Patentblatt 2022/40**

(21) Anmeldenummer: **21161910.1**

(22) Anmeldetag: **11.03.2021**

(51) Internationale Patentklassifikation (IPC):
*G01R 1/20* (2006.01)   *G01R 31/52* (2020.01)
*H02H 1/00* (2006.01)   *H02H 3/26* (2006.01)

(52) Gemeinsame Patentklassifikation (CPC):
*G01R 31/52; G01R 1/203; H02H 5/12;* H02H 3/044

(54) **VERFAHREN UND VORRICHTUNG ZUR ÜBERWACHUNG DER SCHUTZTRENNUNG BEI EINEM STROMERZEUGER**

METHOD AND DEVICE FOR MONITORING THE DISCONNECTION OF A POWER GENERATOR

PROCÉDÉ ET DISPOSITIF DE SURVEILLANCE DE LA SÉPARATION DE PROTECTION DANS UN GÉNÉRATEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **01.04.2020 DE 102020109000**

(43) Veröffentlichungstag der Anmeldung:
**20.10.2021 Patentblatt 2021/42**

(73) Patentinhaber: **Bender GmbH & Co. KG**
**35305 Grünberg (DE)**

(72) Erfinder: **HACKL, Dieter**
**35463 Fernwald (DE)**

(74) Vertreter: **advotec.**
**Patent- und Rechtsanwaltspartnerschaft Tappe mbB**
**Georg-Schlosser-Straße 6**
**35390 Gießen (DE)**

(56) Entgegenhaltungen:
**DE-A1- 19 826 410     US-A1- 2018 334 047**
**US-B2- 8 072 103**

• **Anonymous: "Earthing system - Wikipedia, the free encyclopedia", , 8. März 2014 (2014-03-08), XP055189068, Gefunden im Internet: URL:http://en.wikipedia.org/w/index.php?title=Earthing_system&oldid=598736606 [gefunden am 2015-05-13]**

**Beschreibung**

Die Erfindung betrifft Verfahren und eine Vorrichtung zur Überwachung der Schutztrennung eines Sekundärkreises bei einem Stromerzeuger mit Potenzialausgleichsleiter.

Bei dem Betrieb von Stromerzeugern, insbesondere von mobilen Stromerzeugern, gelangen je nach Einsatzgebiet verschiedene Schutzmaßnahmen gegen elektrischen Schlag zur Anwendung. In Situationen, in denen die Inbetriebnahme des mobilen Stromerzeugers nicht zeitkritisch und eine Elektrofachkraft verfügbar ist, kommt die normative Schutzmaßnahme "Automatische Abschaltung der Stromversorgung" zum Einsatz. Unabhängig von der gewählten Netzform - geerdetes Netz oder ungeerdetes Netz - ist die fachgerechte Schutzerdung der angeschlossenen Betriebsmittel (Verbraucher) ein unverzichtbarer Bestandteil der Schutzmaßnahme.

Speziell in Anwendungen, in denen mobile Stromerzeuger sehr schnell oder ohne Elektrofachkraft in Betrieb genommen werden müssen, gelangt die Schutzmaßnahme Schutztrennung zur Anwendung, deren Anforderungen beispielsweise in Teil 413 der Norm IEC 60364-4-41 beschrieben sind.

Die Schutzwirkung der Schutztrennung ergibt sich demnach dadurch, dass ein unmittelbar mit dem Verbraucher verbundener Sekundärstromkreis (Ausgangswicklung) galvanisch von dem speisenden Netz (Versorgungsnetz) und von Erde getrennt ist bzw. dass bei einem mobilen Stromerzeuger dessen Ausgangswicklung gegenüber Erde getrennt ist. Bei Berühren eines aktiven Leiters des Sekundärstromkreises kann aufgrund des durch die Schutztrennung isolierten Sekundärstromkreises und des damit vorliegenden hohen (ohmschen) Isolationswiderstands sowie aufgrund der geringen Netzableitkapazitäten des Sekundärstromkreises gegen Erde praktisch kein Körperstrom über die berührende Person fließen.

Bei guter Trennung gegen Erde, wenn der Isolationswiderstand hinreichend hochohmig ist und die Ableitkapazität gegen Erde als genügend groß angenommen werden kann, fließt also nur ein kleiner ungefährlicher Körperstrom.

DE 198 26 410 A1 offenbart die Funktionsüberwachung eines Potentialausgleichsleiters.

Ein Problem bei der Schutzmaßnahme Schutztrennung bei mobilen Stromerzeugern ist der notwendige, isolierte Aufbau des Stromerzeugers, der in der Praxis unter den oftmals rauen Einsatzbedingungen nur schwer umzusetzen ist. So kann beispielsweise der Metallrahmen eines Stromerzeugers oder das Metallgehäuse eines Betriebsmittels und damit der Schutzleiter bzw. der Potenzialausgleichsleiter durch zufälligen Kontakt mit dem möglicherweise feuchten Erdreich in Verbindung kommen und somit eine ungewollte Erdverbindung herstellen.

Das Prinzip der Schutztrennung funktioniert somit nicht mehr, wenn die Trennung gegen Erde unzureichend umgesetzt wird und damit insbesondere der Isolationswiderstand als ohmscher Anteil der Ableitimpedanz aufgrund der ungewollten Erdverbindung so klein wird, dass gefährliche Körperströme entstehen können.

Bislang wurde versucht durch Schulungsmaßnahmen, Baustellenaufsicht und Inspektion sowie Wiederholungsprüfungen von elektrischen Betriebsmitteln zu erreichen, dass keine defekten oder gefährlichen Betriebsmittel zum Einsatz kommen und somit ein Bewusstsein über die Gefahren durch elektrischen Schlag bei den auf den Baustellen handelnden Personen entsteht.

Darüber hinaus existieren weitere Vorschriften, die berücksichtigen, dass es auf Bau- und Montagestellen aufgrund der rauen Betriebsbedingungen zu Fehlersituationen kommen kann. Insbesondere können Beschädigungen von Kabeln und Leitungen auftreten und es ist daher erforderlich weitere Schutzmaßnahmen zu treffen.

Beispielsweise werden bei Stromkreisen mit einem Bemessungsstrom größer als 32 Ampere Fehlerstrom-Schutzeinrichtungen (RCDs) mit einem Bemessungsdifferenzstrom kleiner als 500 Milliampere vorgeschrieben. Diese Fehlerstrom-Schutzeinrichtungen sind allerdings nicht zum Schutz gegen elektrischen Schlag geeignet. Auch kann es bei dem Einsatz von Frequenzumrichtern mit betriebsmäßig vorhandenen hohen Ableitströmen häufig zu Fehlauslösungen kommen.

Des Weiteren ist eine niederohmige Erdung Voraussetzung für die einwandfreie Funktion einer Fehlerstrom-Schutzeinrichtung. Bei der Schutzmaßnahme Schutztrennung auf Bau- und Montagestellen kann jedoch aufgrund der Betriebsbedingungen auch eine doppelte oder verstärkte Isolierung von Kabeln und Leitungen fehlerhaft sein. Dabei ist damit zu rechnen, dass beispielsweise über ein auf feuchtem Boden liegendes fehlerhaftes Kabel keine niederohmige Fehlerschleife entsteht und somit die Fehlerstrom-Schutzeinrichtungen nicht zuverlässig vor elektrischem Schlag schützen können.

Auch können nasse Handmaschinen, beispielsweise die Nutzung von Trennschleifmaschinen auf Baustellen im Regen, zu Körperströmen parallel zu dem Lastwiderstand führen. Diese Körperströme führen nicht zu RCD-wirksamen Fehlerströmen und damit nicht zur automatischen Abschaltung im Fehlerfall.

Eine Begrenzung der Strömungsdauer über den menschlichen Körper mittels automatischer Abschaltung der Stromversorgung ist aber zwingend erforderlich, da sich die berührende Person oberhalb einer Loslass-Schwelle nicht mehr selbst aus dieser Körperstromsituation befreien kann.

Der internationale Standard IEC60479-1:2018 beschreibt in Fig. 20 die physiologische Wirkung von Wechselströmen auf Personen bei der Berührung stromführender Teile einer elektrischen Anlage. Dargestellt ist die Dauer des Körperstroms (Durchströmungsdauer) über der Höhe des Körperstroms $I_k$. Dabei existieren in

ihrer Wirkung auf den Menschen unterschiedlich gefährliche Zeit-Stromstärkebereiche AC-1 bis AC-4 mit Körperstrom-Schwellen A, B, C, die die Gefährlichkeit der Wirkungen voneinander abgrenzen. Insbesondere oberhalb der Schwelle D von 5 mA (Loslass-Schwelle) treten in dem Bereich AC3 gefährliche Körperstromsituationen auf. Bis zu einer Schwelle von 30 mA, welche dem Auslösestrom einer normativ vorgeschriebenen Fehlerstrom-Schutzeinrichtung RCD entspricht, ist kein sicherer Schutz gegeben, sodass eine Sicherheitslücke zwischen einem Fehlerstrom von 5 mA und 30 mA besteht. Diese Sicherheitslücke gilt es mit der vorliegenden Erfindung zu schließen, bzw. vor Gefahren in diesem Strombereich zu warnen.

Insbesondere für die beschriebenen rauen Betriebsbedingungen auf Bau- und Montagestellen stellt der Körperstrombereich zwischen 5 mA und 30 mA eine Schutzlücke dar, die bislang trotz des hohen Aufwands an Überwachungs- und Schutzeinrichtungen nicht hinreichend abgedeckt ist.

Der vorliegenden Erfindung liegt somit die Aufgabe zugrunde, die Schutztrennung bei einem Stromerzeuger, insbesondere bei einem mobilen Stromerzeuger zu überwachen und vor möglichen gefährlichen Körperströmen zu warnen.

Diese Aufgabe wird durch ein Verfahren mit den Merkmalen des Anspruchs 1 gelöst.

Der erfinderische Grundgedanke liegt darin, dass zwischen den Potenzialausgleichsleiter des Stromerzeugers und Erde eine Überwachungseinrichtung installiert wird, mit der festgestellt werden kann, welcher mögliche maximale Körperstrom bei einer direkten Berührung eines aktiven Leiters durch eine Person fließen würde, ohne dass diese Berührung stattfindet. Überschreitet der erfindungsgemäß ermittelte, potenzielle Körperstrom einen festgelegten Körperstromgrenzwert, erfolgt das Ausgeben eines Warnsignals.

Dazu ist zunächst in einem Schritt (a) das Anbringen einer Funktionserdung für messtechnische Zwecke erforderlich. Die Funktionserdung als temporäre Erdverbindung dient zur Durchführung der erfindungsgemäßen messtechnischen Überwachung und kann ohne weiteres von einem elektrotechnischen Laien erstellt werden.

In Schritt (b) erfolgt das Messen einer ersten Spannung an einer zwischen dem Potenzialausgleichsleiter und der Funktionserdung geschalteten veränderbaren Messimpedanz. Die veränderbare Messimpedanz kann als umschaltbare oder einstellbare Messimpedanz ausgeführt werden und besitzt für die Messung der ersten Spannung (Initialmessung) einen ersten Impedanzwert.

Als nächster Schritt (c) erfolgt ein Vergleichen der gemessenen ersten Spannung mit einem Spannungsgrenzwert.

Wird in einem darauffolgenden Schritt (d) festgestellt, dass die gemessene erste Spannung diesen Spannungsgrenzwert überschreitet, wird eine zweite Spannung an der zwischen dem Potenzialausgleichsleiter und der Funktionserdung geschalteten veränderbaren Messimpedanz vorgenommen. Bei dieser zweiten Messung weist die Messimpedanz einen von dem ersten Impedanzwert verschiedenen zweiten Impedanzwert auf.

Anschließend erfolgt in Schritt (e) ein Ermitteln einer jeweiligen Phasenlage der ersten und der zweiten Spannung. Für die weiteren Berechnungen müssen die jeweiligen Phasenlagen der ersten und der zweiten Spannung bekannt sein, sofern diese nicht implizit durch das Auswerten komplexwertiger Impedanzwerte (vgl. Anspruch 3) bekannt sind.

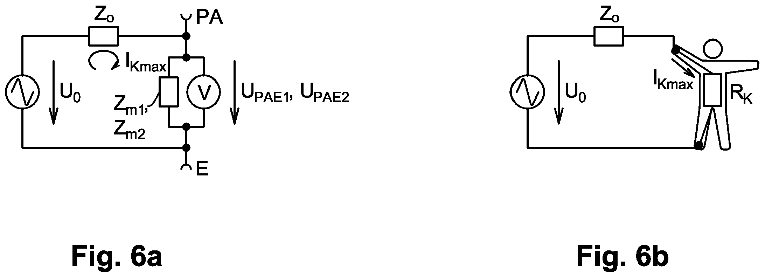

Aus der ersten Spannung, der zweiten Spannung, dem ersten Impedanzwert und dem zweiten Impedanzwert werden in einem folgenden Schritt (f) eine Quellimpedanz und eine Quellspannung ermittelt. Die Quellspannung und die Quellimpedanz können dabei jeweils als fiktive Größen eines Ersatzschaltbildes (siehe Fig. 6) zur Bestimmung eines möglichen maximalen Körperstroms aufgefasst werden, wobei die Quellspannung den Körperstrom treibt.

Dieser maximale Körperstrom wird in einem folgenden Schritt (g) aus der Quellspannung und der Quellimpedanz mit der Annahme eines vernachlässigbaren Körperwiderstands der berührenden Person bestimmt, sodass nur die Quellimpedanz als Körperstrom-begrenzende Impedanz wirkt.

In einem abschließenden Schritt (h) wird geprüft, ob der maximale Körperstrom einen Körperstromgrenzwert überschreitet. Im Falle einer Überschreitung wird ein Warnsignal ausgegeben und gegebenenfalls ein Abschalten der durch den Stromerzeuger bereitgestellten Spannungsversorgung eingeleitet.

In einer vorteilhaften Ausgestaltung ist der erste Impedanzwert reell und hochohmig und der zweite Impedanzwert ist reell und kleiner als der erste Impedanzwert, aber noch so hochohmig, dass die normative Schutztrennung nicht gefährdet ist.

Die Messung der ersten Spannung geht von einer Spannungsteilerschaltung (siehe Fig. 6) aus, bei der im Fall des ersten hochohmigen Impedanzwertes (Grenzwertbetrachtung mit einem gegen Unendlich gehenden ersten Impedanzwert) die Quellenspannung der ersten Spannung entspricht. Aus der Messung der zweiten Spannung mit der aus der ersten Messung bekannten ersten Spannung als Quellenspannung und dem bekannten zweiten Impedanzwert kann die Quellenimpedanz und weiter der maximale Körperstrom bestimmt werden.

Das Ermitteln der jeweiligen Phasenlage der ersten Spannung und der zweiten Spannung erfolgt gegenüber einer Referenzspannung - vorzugsweise durch eine Schaltung, die PLL (Phase-locked loop) Funktionalität aufweist.

In alternativer Ausgestaltung zu dem reellen und hochohmig ausgeführten ersten Impedanzwert und dem reellen zweiten Impedanzwert ist mindestens einer der beiden Impedanzwerte komplexwertig. In diesem Fall ist keine Referenzspannung erforderlich, sondern das Ermitteln der jeweiligen Phasenlage der ersten Spannung und der zweiten Spannung ist implizit in der Auswertung des komplexwertigen Impedanzwertes oder beider komplexwertiger Impedanzwerte enthalten. Aus den Messungen geht ein lineares komplexwertiges Gleichungssystem hervor, aus dem sich die Quellenspannung und die Quellenimpedanz bestimmen lassen.

Ein alternatives Lösungsverfahren der zugrundeliegenden Aufgabe besteht in einer zweifachen frequenzselektiven Spannungsmessung.

Hier besteht die erfindungsgemäße Grundidee darin, das Messen der ersten Spannung und das Messen der zweiten Spannung bei unterschiedlichen Frequenzen durchzuführen und in Verbindung mit den voneinander unterschiedlichen ersten und zweiten Impedanzwerten aus dem so entstehenden linearen komplexwertigen Gleichungssystem die Quellspannung und die Quellimpedanz bestimmen zu können.

Dazu wird zunächst in einem Schritt (a) wiederum eine Funktionserdung für messtechnische Zwecke angebracht.

Danach erfolgt in einem Schritt (b) das Messen einer ersten Spannung mit einer ersten Messfrequenz an einer zwischen dem Potenzialausgleichsleiter und der Funktionserdung geschalteten veränderbaren Messimpedanz, wobei die Messimpedanz einen ersten Impedanzwert aufweist.

In dem folgenden Schritt (c) wird die erste Spannung mit einem Spannungsgrenzwert verglichen und in einem anschließenden Schritt (d), falls die erste Spannung den Spannungsgrenzwert überschreitet, eine zweite Spannung mit einer von der ersten Messfrequenz verschiedenen zweiten Messfrequenz an der zwischen dem Potenzialausgleichsleiter und der Funktionserdung geschalteten veränderbaren Messimpedanz gemessen. Die Messimpedanz weist für diese zweite Spannungsmessung einen zweiten Impedanzwert auf, der verschieden von dem ersten Impedanzwert ist.

Danach erfolgt in Schritt (e) ein Bestimmen einer Quellimpedanz und einer Quellspannung auf der Basis des von dem durch die gemessene erste und zweite Spannung und den bekannten ersten und zweiten Impedanzwerten bestimmten linearen komplexwertigen Gleichungssystems.

Die Phasenlagen der jeweiligen gemessenen Spannungen werden dabei implizit durch die komplexwertigen Impedanzwerte berücksichtigt, sodass auf eine Ermittlung der Phasenlagen mittels einer Referenzspannung verzichtet werden kann.

In dem Schritt (f) wird der maximale Körperstrom aus der Quellspannung und der Quellimpedanz bestimmt.

In Schritt (g) wird anschließend geprüft, ob der maximale Körperstrom einen Körperstromgrenzwert überschreitet. Bei Überschreitung erfolgt das Ausgeben eines Warnsignals, gegebenenfalls in Verbindung mit einem Abschalten der Spannungsversorgung.

Die Umsetzung der vorgenannten Verfahren erfolgt in erfindungsgemäßen Überwachungsvorrichtungen, die die zur Durchführung der Verfahren erforderlichen Vorrichtungsmerkmale aufweisen, sodass die oben genannten Vorteile gleichermaßen für die im Folgenden aufgeführten körperlichen Merkmale gelten.

Die Überwachungsvorrichtung weist dazu eine Funktionserdung für messtechnische Zwecke auf, eine zwischen den Potenzialausgleichsleiter und der Funktionserdung geschaltete veränderbare Messimpedanz, die einen ersten Impedanzwert oder einen von dem ersten Impedanzwert verschiedenen einen zweiten Impedanzwert annehmen kann, einen Spannungsmesser zur Messung einer über der veränderlichen Messimpedanz abfallenden ersten und zweiten Spannung sowie eine Recheneinheit, welche konfiguriert ist zum Vergleichen der ersten Spannung mit einem Spannungsgrenzwert, zur Ermittlung von einer jeweiligen Phasenlage der ersten und der zweiten Spannung, zur Bestimmung einer Quellimpedanz und einer Quellspannung, zur Bestimmung eines maximalen Körperstroms, zur Prüfung, ob der maximale Körperstrom einen Körperstromgrenzwert überschreitet und zur Ausgabe eines Warnsignals bei Überschreitung.

Mit Vorteil ist die Überwachungsvorrichtung so ausgestaltet, dass der erste Impedanzwert reell und hochohmig ist und der zweite Impedanzwert reell und kleiner als der erste Impedanzwert ist.

Die Recheneinheit ist so konfiguriert, dass die jeweilige Phasenlage der ersten Spannung und der zweiten Spannung gegenüber einer Referenzspannung ermittelt wird.

In einer alternativen Ausgestaltung der veränderbaren Messimpedanz ist mindestens einer der beiden Impedanzwerte komplexwertig. In diesem Fall ist die Recheneinheit zur Ermittlung der jeweiligen Phasenlage der ersten Spannung und der zweiten Spannung so ausgelegt, dass eine implizite Auswertung des komplexwertigen Impedanzwerts oder der komplexwertigen Impedanzwerte erfolgt. Eine explizite Phasenbestimmung über eine Referenzspannung ist somit nicht erforderlich.

In einer weiteren alternativen Ausgestaltung ist der Spannungsmesser frequenzselektiv ausgeführt. In dieser Ausgestaltung ist der Spannungsmesser in der Lage, die Messung der ersten und der zweiten Spannung mit verschiedenen Messfrequenzen durchzuführen, wobei in Verbindung mit den zwei unterschiedlichen Impedanzwerten ein lineares komplexwertiges Gleichungssystem entsteht, aus dem die Quellspannung und die Quellimpedanz abgeleitet werden können.

Weitere vorteilhafte Ausgestaltungsmerkmale ergeben sich aus der nachfolgenden Beschreibung und den Zeichnungen, die bevorzugte Ausführungsformen der Erfindung anhand von Beispielen erläutern.

Es zeigen:

**Fig. 1** das Prinzip der Schutzmaßnahme Schutztrennung,

Fig. 2    eine Gefahrensituation durch unerkannten Fehlerstrom,

Fig. 3    eine erfindungsgemäße Überwachungsvorrichtung in bevorzugter Ausführungsform,

Fig. 4    eine erfindungsgemäße Überwachungsvorrichtung in alternativer Ausgestaltung,

Fig. 5    eine erfindungsgemäße Überwachungsvorrichtung in weiterer alternativer Ausgestaltung und

Fig. 6a, 6b    Ersatzschaltbilder zur Bestimmung eines maximalen Körperstroms.

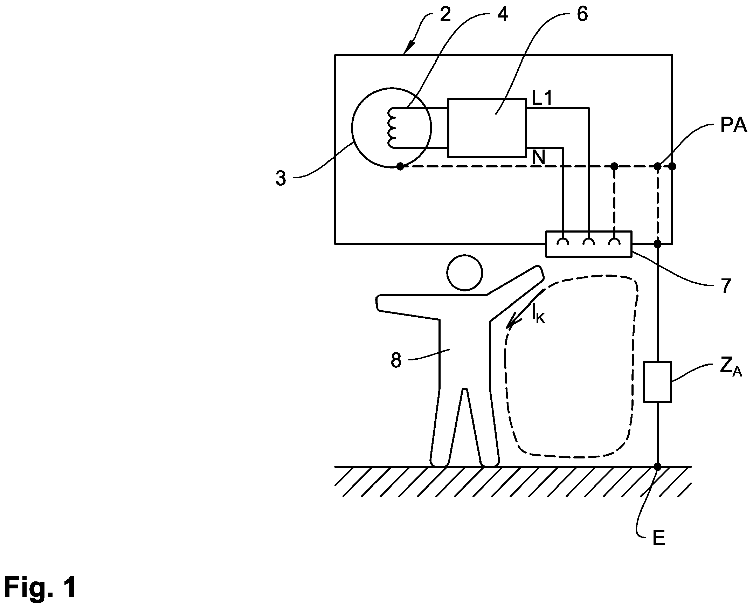

Fig. 1 zeigt in einer vereinfachten Darstellung das Prinzip der Schutzmaßnahme Schutztrennung.

Ein Stromerzeuger 2 stellt an einer Steckverbindung 7 (Steckdose) über einen Sekundärstromkreis 4 (Ausgangswicklung) eine Ausgangsspannung bereit. Der Sekundärstromkreis 4 besteht aus aktiven Leitern $L_1$ (Phasenleiter) um N (Neutralleiter) und ist über eine Überstromschutzeinrichtung 6 abgesichert. Das Gehäuse 3 des Stromerzeugers 2 ist mit dem ungeerdeten Potenzialausgleichsleiter PA verbunden. Der Stromerzeuger 2 kann ein mobiler Generator zur Stromversorgung auf Baustellen, beispielsweise zum Betrieb von Handgeräten, sein.

Sämtliche aktiven Teile des Stromerzeugers 2 sind gegenüber Erde E isoliert, der Sekundärstromkreis 4 stellt damit ein ungeerdetes Stromversorgungssystem dar. Zwischen dem Stromerzeuger 2 und Erde E existiert eine unvermeidliche Ableitimpedanz $Z_A$, bestehend aus einem reellen Isolationswiderstand und einer Ableitkapazität. Im Idealfall nimmt die Ableitimpedanz $Z_A$ einen unendlich großen Wert an, sodass sich bei Berührung des Stromerzeugers 2 durch eine Person 8 kein geschlossener Stromkreis ausbilden kann oder die Ableitimpedanz $Z_A$ ist so groß, dass der als Fehlerstrom über dem menschlichen Körper 8 fließende Körperstrom $I_k$ ungefährlich ist.

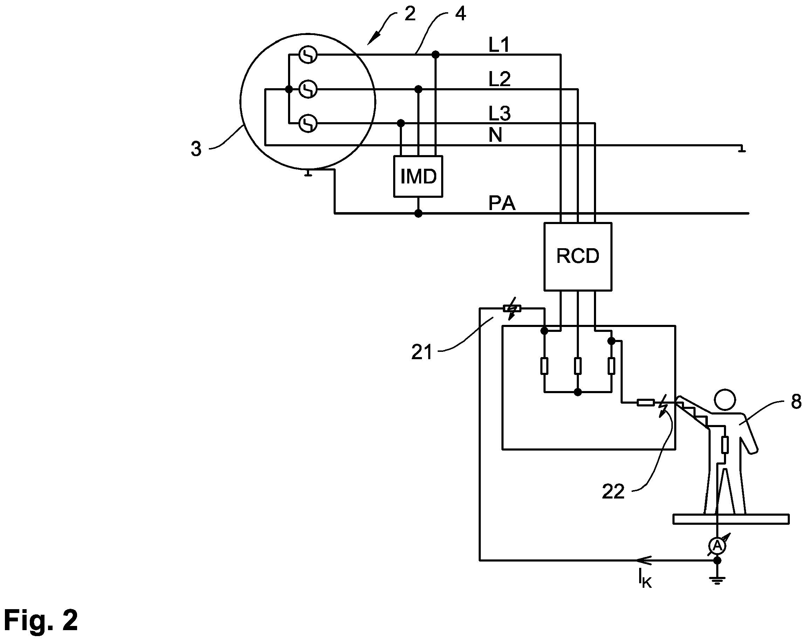

Fig. 2 zeigt die Entstehung einer Gefahrensituation durch einen unerkannten Fehlerstrom.

Obwohl in dieser Simulationsanordnung eine zusätzliche Fehlerstrom-Schutzeinrichtung RCD vorgesehen ist, bleibt diese wirkungslos, wenn durch einen ersten Fehler 21, beispielsweise ausgelöst durch einen feuchte Steckverbindung 7 (Fig. 1), an einem ersten aktiven Leiter $L_1$ eine Erdverbindung entsteht und an einem anderen aktiven Leiter $L_3$ durch einen Isolationsfehler 22 (zweiter Fehler) in Verbindung mit der Berührung durch eine Person 8 ein Körperstrom $I_k$ als Fehlerstrom fließt.

Da dieser Körperstrom $I_k$ auf seinem Hin- und Rückweg durch die Fehlerstrom-Schutzeinrichtung RCD fließt - also kein Differenzstrom in der Fehlerstrom-Schutzeinrichtung RCD messbar ist - bleibt der Körperstrom $I_k$ in der Fehlerstrom-Schutzeinrichtung RCD unbemerkt. Die Fehlerstrom-Schutzeinrichtung RCD löst somit nicht aus, obwohl ein Fehlerstrom, hier in der simulierten Größenordnung von 180 mA, über die Person 8 fließt.

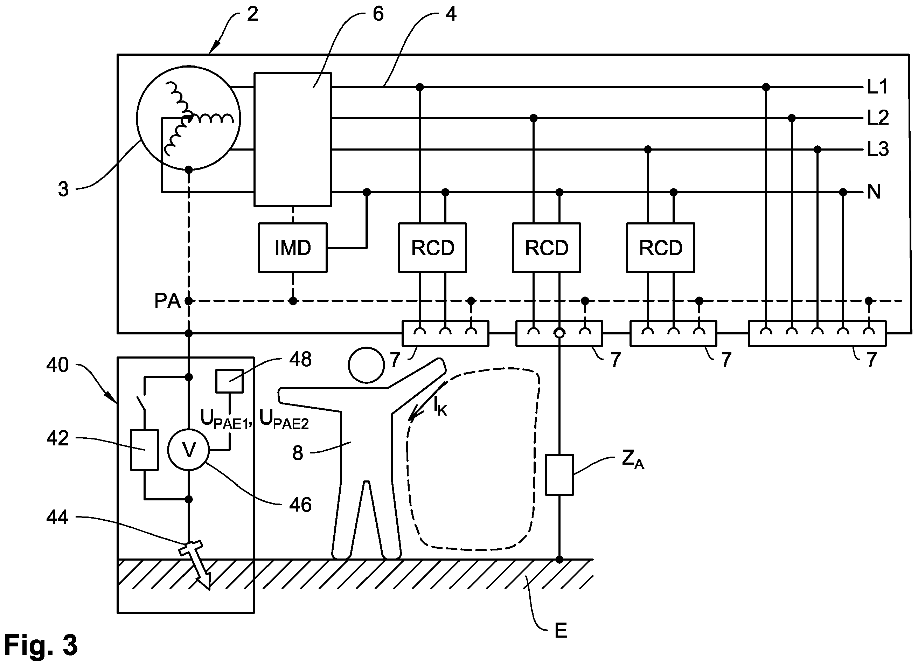

Fig. 3 zeigt eine erfindungsgemäße Überwachungsvorrichtung in einer bevorzugten, ersten Ausführung.

Der (mobile) Stromerzeuger 2 weist hier einen dreiphasigen Sekundärstromkreis 4 mit den aktiven Leitern $L_1$, $L_2$, $L_3$, N auf, wobei die Außenleiter $L_1$, $L_2$, $L_3$ jeweils über eine separate Fehlerstrom-Schutzeinrichtung RCD abgesichert sind. Neben der Überstromschutzeinrichtung 6 weist der Stromerzeuger 2 ein Isolationsüberwachungsgerät IMD auf, das zwischen den Neutralleiter N und den Potenzialausgleichsleiter PA zur Überwachung des Isolationswiderstandes (ohmscher Anteil der dargestellten Ableitimpedanz $Z_A$) geschaltet ist.

Die erfindungsgemäße Überwachungsvorrichtung 40 weist eine Funktionserdung 44 auf, die über eine veränderbare Messimpedanz 42, welche einen ersten Impedanzwert $Z_{m1}$ und einen zweiten Impedanzwert $Z_{m2}$ annehmen kann, mit dem Potenzialausgleichsleiter PA verbunden ist.

Über der veränderbaren Messimpedanz 42 werden bei der Netzfrequenz mit einem Spannungsmesser 46 eine erste Spannung $U_{PAE1}$ bei Aufschalten eines ersten Impedanzwertes $Z_{m1}$ und eine zweite Spannung $U_{PAE2}$ bei Aufschalten eines zweiten Impedanzwertes $Z_{m2}$ erfasst. Die Messergebnisse werden an eine Recheneinheit 48 zur Ermittlung der jeweiligen Phasenlage der ersten Spannung $U_{PAE1}$ und der zweiten Spannung $U_{PAE2}$ gegenüber einer Referenzspannung weitergeleitet.

Aus den Messungen der ersten und zweiten Spannung $U_{PAE1}$, $U_{PAE2}$ kann in Verbindung mit den bekannten ersten und zweiten Impedanzwerten $Z_{m1}$, $Z_{m2}$ eine Quellspannung Uo und eine Quellimpedanz Zo für ein Ersatzschaltbild (Fig. 6) berechnet werden, welches zur Bestimmung eines möglichen maximalen Körperstroms Ikmax dient..

In einer bevorzugten Ausgestaltung ist der für die erste Spannungsmessung $U_{PAE1}$ verwendete erste Impedanzwert $Z_{m1}$ reell und so hochohmig, dass die in dem Ersatzschaltbild (Fig. 6) ermittelte Quellspannung Uo näherungsweise der tatsächlich gemessenen ersten Spannung $U_{PAE1}$ entspricht.

Der für die Messung der zweiten Spannung $U_{PAE2}$ verwendetet zweite Impedanzwert $Z_{m2}$ ist dabei reell und kleiner als der ersten Impedanzwert $Z_{m1}$, jedoch noch so hochohmig, dass die vorgeschriebene Schutztrennung nicht gefährdet ist.

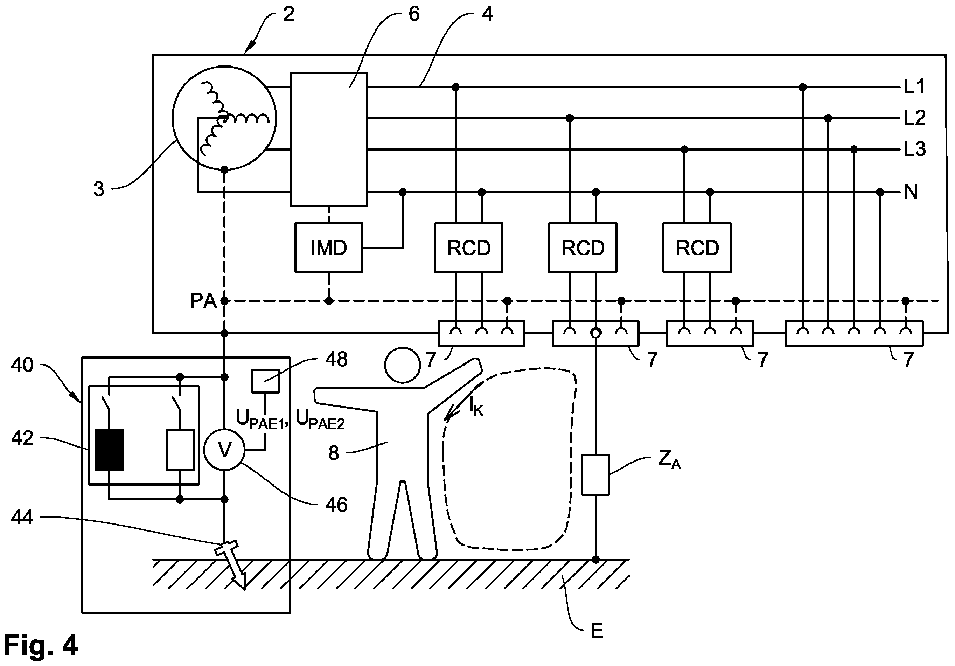

Fig. 4 zeigt die erfindungsgemäße Überwachungsvorrichtung 40 in einer alternativen Ausführungsform.

In dieser Ausführungsform ist die veränderbare Messimpedanz 42 so ausgeführt, dass mindestens einer

der beiden Impedanzwerte $Z_{m1}$, $Z_{m2}$ komplexwertig ist. Dies ist beispielsweise dadurch erreichbar, dass - statt des Umschaltens von rein ohmschen Impedanzwerten - zwischen einem ohmschen ersten Impedanzwert $Z_{m1}$ und einem komplexwertigen zweiten Impedanzwert $Z_{m2}$, beispielsweise durch Zuschalten einer Induktivität oder Kapazität, umgeschaltet wird.

Allerdings ist das Schalten von Energiespeichern wie Induktivitäten oder Kapazitäten nicht unkritisch und kann zu Spannungs- und/oder Stromspitzen führen.

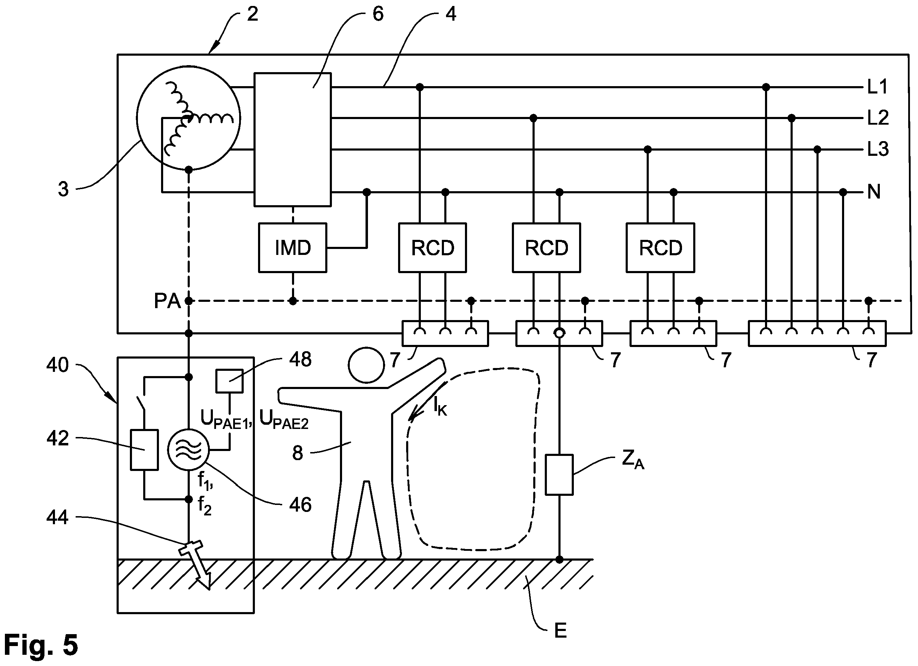

**Fig. 5** zeigt eine weitere Ausführungsform der erfindungsgemäßen Überwachungsvorrichtung 40.

In dieser Ausführungsform wird eine frequenzselektive Messung der ersten und der zweiten Spannung $U_{PAE1}$, $U_{PAE2}$ durchgeführt. Unter der Voraussetzung, dass in dem Frequenzspektrum der gemessenen Spannungen $U_{PAE1}$, $U_{PAE2}$ auch Frequenzkomponenten enthalten sind, die eine von der Netzfrequenz abweichende bekannte Frequenz mit ausreichender Amplitude besitzen, also beispielsweise eine dritte Harmonische der Netzfrequenz, reicht die frequenzselektive Erfassung des Effektivwertes der ersten und der zweiten Spannung $U_{PAE1}$, $U_{PAE2}$ bei mindestens zwei verschiedenen Frequenzen $f_1$, $f_2$ und mit zwei unterschiedlichen ersten und zweiten Impedanzwerten $Z_{m1}$, $Z_{m2}$ aus, um aus dem so entstehenden linearen, komplexen Gleichungssystem die Quellspannung Uo und die Quellimpedanz Zo bestimmen zu können.

Eine Bestimmung der Phasenlage über eine Referenzspannung ist nicht erforderlich.

Allerdings ist das Vorhandensein hinreichend großer Frequenzkomponenten als Voraussetzung für die Anwendung dieser Ausführungsform nicht sicher in allen Anwendungsumgebungen gegeben.

Die **Fig. 6a, 6b** zeigen Ersatzschaltbilder zur Bestimmung eines maximalen Körperstroms Ikmax für die bevorzugte Ausführungsform mit dem ersten reellen und hochohmigen Impedanzwert $Z_{m1}$ und dem zweiten Impedanzwert $Z_{m2}$, der reell und kleiner als der erste Impedanzwert $Z_{m1}$ ist.

Aus der ersten Spannungsmessung $U_{PAE1}$ kann mit hinreichend hochohmigem ersten Impedanzwert $Z_{m1}$ (Grenzwertbetrachung für $Z_{m1}$ gegen unendlich) mittels der Spannungsteilregel die Quellspannung Uo in dem Ersatzschaltbild so bestimmt werden, dass diese der gemessenen ersten Spannung $U_{PAE1}$ entspricht (UPAEI = Uo):

$$U_{\mathrm{PAE1,2}}\left(Z_0, U_0, Z_{m1,2}\right) = U_0 \cdot \frac{Z_{m1,2}}{Z_{m1,2} + Z_0}$$

Die Quellimpedanz Zo entspricht einer Parallelschaltung des Isolationswiderstands und der Ableitkapazität (komplexwertige Summe beider Leitwerte) und ergibt sich betragsmäßig zu

$$Z_0 = \left| \left( \frac{U_{PAE1}}{U_{PAE2}} - 1 \right) \cdot Z_{m2} \right|$$

Hieraus wiederum kann mit $U_{PAE1}$ = Uo der maximal - bei vernachlässigbarem Körperwiderstand der Person - erwartbare Körperstrom Ikmax berechnet werden:

$$I_{kmax} = \frac{U_0}{Z_0}$$

Die vorliegende Erfindung ermöglicht somit durch zwei Spannungsmessungen $U_{PAE1}$, $U_{PAE2}$ mit zweit verschieden Impedanzwerten $Z_{m1}$, $Z_{m2}$ einen im Fehlerfall zu erwartenden maximalen Körperstrom $I_{kmax}$ zu ermitteln.

**Patentansprüche**

1. Verfahren zur Überwachung der Schutztrennung eines Sekundärkreises bei einem Stromerzeuger mit Potentialausgleichsleiter (PA), **gekennzeichnet durch** die Verfahrensschritte:

    (a) Anbringen einer Funktionserdung (44) für messtechnische Zwecke,
    (b) Messen einer ersten Spannung ($U_{PAE1}$) an einer zwischen dem Potentialausgleichsleiter (PA) und der Funktionserdung (44) geschalteten veränderbaren Messimpedanz (42), wobei die Messimpedanz einen ersten Impedanzwert ($Z_{m1}$) aufweist,
    (c) Vergleichen der ersten Spannung ($U_{PAE1}$) mit einem SpannungsGrenzwert,
    (d) Falls die erste Spannung ($U_{PAE1}$) den Spannungsgrenzwert überschreitet, Messen einer zweiten Spannung ($U_{PAE2}$) an der zwischen dem Potentialausgleichsleiter (PA) und der Funktionserdung (44) geschalteten veränderbaren Messimpedanz, wobei die Messimpedanz einen von dem ersten Impedanzwert ($Z_{m1}$) verschiedenen zweiten Impedanzwert ($Z_{m2}$) aufweist,
    (e) Ermitteln einer jeweiligen Phasenlage der ersten und der zweiten Spannung ($U_{PAE1}$, $U_{PAE2}$),
    (f) Bestimmen einer Quellimpedanz ($Z_0$) und einer Quellspannung **($U_0$)** aus der ersten Spannung ($U_{PAE1}$), der zweiten Spannung ($U_{PAE2}$) dem ersten Impedanzwert (Zm1) und dem zweiten Impedanzwert ($Z_{m2}$),
    (g) Bestimmen eines maximalen Körperstroms ($I_{kmax}$) aus der Quellspannung ($U_0$) und der Quellimpedanz ($Z_0$),
    (h) Prüfen, ob der maximale Körperstrom ($I_{kmax}$)

einen KörperstromGrenzwert überschreitet und Ausgeben eines Warnsignals bei Überschreitung.

2.  Verfahren nach Anspruch 1, **dadurch gekennzeichnet, dass** der erste Impedanzwert ($Z_{m1}$) reell und hochohmig ist und der zweite Impedanzwert ($Z_{m2}$) reell und kleiner als der erste Impedanzwert ($Z_{m1}$) ist, wobei das Ermitteln der jeweiligen Phasenlage der ersten Spannung ($U_{PAE1}$) und der zweiten Spannung ($U_{PAE2}$) gegenüber einer Referenzspannung erfolgt.

3.  Verfahren nach Anspruch 1, **dadurch gekennzeichnet, dass** mindestens einer der beiden Impedanzwerte ($Z_{m1}$, $Z_{m2}$) komplexwertig ist, wobei das Ermitteln der jeweiligen Phasenlage der ersten Spannung ($U_{PAE1}$) und der zweiten Spannung ($U_{PAE2}$) implizit durch Auswerten des komplexwertigen Impedanzwertes ($Z_{m1}$, $Z_{m2}$) oder der komplexwertigen Impedanzwerte ($Z_{m1}$, $Z_{m2}$) erfolgt.

4.  Verfahren zur Überwachung der Schutztrennung eines Sekundärkreises bei einem Stromerzeuger mit Potentialausgleichsleiter (PA), **gekennzeichnet durch** die Verfahrensschritte:

    (a) Anbringen einer Funktionserdung (44) für messtechnische Zwecke,
    (b) Messen einer ersten Spannung ($U_{PAE1}$) mit einer ersten Messfrequenz an einer zwischen dem Potentialausgleichsleiter (PA) und der Funktionserdung (44) geschalteten veränderbaren Messimpedanz, wobei die Messimpedanz einen ersten Impedanzwert ($Z_{m1}$) aufweist,
    (c) Vergleichen der ersten Spannung ($U_{PAE1}$) mit einem SpannungsGrenzwert,
    (d) Falls die erste Spannung den Spannungsgrenzwert überschreitet, Messen einer zweiten Spannung ($U_{PAE2}$) mit einer von der ersten Messfrequenz verschiedenen zweiten Messfrequenz an der zwischen dem Potentialausgleichsleiter (PA) und der Funktionserdung (44) geschalteten veränderbaren Messimpedanz, wobei die Messimpedanz einen zweiten Impedanzwert ($Z_{m2}$) aufweist, der verschieden von dem ersten Impedanzwert ($Z_{m1}$) ist,
    (e) Bestimmen einer Quellimpedanz ($Z_0$) und einer Quellspannung ($U_0$) aus der ersten Spannung ($U_{PAE1}$), der zweiten Spannung ($U_{PAE2}$), dem ersten Impedanzwert ($Z_{m1}$) und dem zweiten Impedanzwert ($Z_{m2}$),
    (f) Bestimmen eines maximalen Körperstroms ($I_{kmax}$) aus der Quellspannung ($U_0$) und der Quellimpedanz ($Z_0$),
    (g) Prüfen, ob der maximale Körperstrom ($I_{kmax}$)

einen KörperstromGrenzwert überschreitet und Ausgeben eines Warnsignals bei Überschreitung.

5.  Überwachungsvorrichtung zur Durchführung eines der Verfahren nach den Ansprüchen 1 bis 4 zur Überwachung der Schutztrennung eines Sekundärkreises bei einem Stromerzeuger mit Potentialausgleichsleiter (PA), **gekennzeichnet durch**

    eine Funktionserdung (44),
    eine zwischen dem Potentialausgleichsleiter (PA) und der Funktionserdung (44) geschalteten veränderbaren Messimpedanz (42), die einen ersten Impedanzwert ($Z_{m1}$) oder einen von dem ersten Impedanzwert ($Z_{m1}$) verschiedenen zweiten Impedanzwert ($Z_{m2}$) annehmen kann,
    einen Spannungsmesser (46) zur Messung einer über der veränderbaren Messimpedanz (42) abfallenden ersten und zweiten Spannung ($U_{PAE1}$, $U_{PAE2}$),
    eine Recheneinheit (48) konfiguriert zum Vergleichen der ersten Spannung ($U_{PAE1}$) mit einem Spannungs-Grenzwert, zur Ermittlung von einer jeweiligen Phasenlage der ersten und der zweiten Spannung ($U_{PAE1}$, $U_{PAE2}$), zur Bestimmung einer Quellimpedanz ($Z_0$) und einer Quellspannung ($U_0$), zur Bestimmung eines maximalen Körperstroms ($I_{kmax}$), zur Prüfung, ob der maximale Körperstrom ($I_{kmax}$) einen Körperstrom-Grenzwert überschreitet und zur Ausgabe eines Warnsignals bei Überschreitung.

6.  Überwachungsvorrichtung nach Anspruch 5, **dadurch gekennzeichnet, dass** der erste Impedanzwert ($Z_{m1}$) reell und hochohmig ist und der zweite Impedanzwert ($Z_{m2}$) reell und kleiner als der erste Impedanzwert ($Z_{m1}$) ist, und die Recheneinheit (48) zur Ermittlung der jeweiligen Phasenlage der ersten Spannung ($U_{PAE1}$) und der zweiten Spannung ($U_{PAE2}$) gegenüber einer Referenzspannung ausgelegt ist.

7.  Überwachungsvorrichtung nach Anspruch 5, **dadurch gekennzeichnet, dass** mindestens einer der beiden Impedanzwerte ($Z_{m1}$, $Z_{m2}$) komplexwertig ist und die Recheneinheit (48) zur Ermittlung der jeweiligen Phasenlage der ersten Spannung ($U_{PAE1}$) und der zweiten Spannung ($U_{PAE2}$) ist so ausgelegt, dass eine implizite Auswertung des komplexwertigen Impedanzwertes ($Z_{m1}$, $Z_{m2}$) oder der komplexwertigen Impedanzwerte ($Z_{m1}$, $Z_{m2}$) erfolgt.

8.  Überwachungsvorrichtung nach Anspruch 5, **dadurch gekennzeichnet, dass** der Spannungsmesser (46) frequenzselektiv ausgeführt ist.

**Claims**

1. A method for monitoring the protection separation of a secondary circuit in a current generator having an equipotential bonding conductor (PA), **characterized by** the method steps:

   (a) applying a functional grounding (44) for measuring purposes,
   (b) measuring a first voltage ($U_{PAE1}$) at a alterable measuring impedance (42) switched between the equipotential bonding conductor (PA) and the functional grounding (44), the measuring impedance having a first impedance value ($Z_{m1}$),
   (c) comparing the first voltage ($U_{PAE1}$) to a voltage threshold
   (d) if the first voltage ($U_{PAE1}$) exceeds the voltage threshold, measuring a second voltage ($U_{PAE2}$) at the alterable measuring impedance switched between the equipotential bonding conductor (PA) and the functional grounding (44), the measuring impedance having a second impedance value ($Z_{m2}$) different to the first impedance value ($Z_{m1}$),
   (e) detecting a corresponding phasing of the first and the second voltage ($U_{PAE1}$, $U_{PAE2}$),
   (f) determining a source impedance ($Z_0$) and a source voltage (Uo) from the first voltage ($U_{PAE1}$), the second voltage ($U_{PAE2}$), the first impedance value ($Z_{m1}$) and the second impedance value ($Z_{m2}$),
   (g) determining a maximal shock current ($I_{kmax}$) from the source voltage ($U_0$) and the source impedance ($Z_0$),
   (h) testing whether the maximal shock current ($I_{kmax}$) exceeds a shock current threshold and emitting a warning signal when exceeded.

2. The method according to claim 1,
   **characterized in that**
   the first impedance value ($Z_{m1}$) is real-valued and has a high impedance and the second impedance value ($Z_{m2}$) is real-valued and smaller than the first impedance value ($Z_{m1}$), the corresponding phasing of the first voltage ($U_{PAE1}$) and the second voltage ($U_{PAE2}$) being detected with respect to a reference voltage.

3. The method according to claim 1,
   **characterized in that**
   at least one of the two impedance values ($Z_{m1}$, $Z_{m2}$) is complex-valued, the corresponding phasing of the first voltage ($U_{PAE1}$) and the second voltage ($U_{PAE2}$) being detected implicitly by evaluating the complex-valued impedance value ($Z_{m1}$, $Z_{m2}$) or the complex-valued impedance values ($Z_{m1}$, $Z_{m2}$).

4. A method for monitoring the protection separation of a secondary circuit in a current generator having an equipotential bonding conductor (PA), **characterized by** the method steps:

   (a) applying a functional grounding (44) for measuring purposes,
   (b) measuring a first voltage ($U_{PAE1}$) at a alterable measuring impedance, which is switched between the equipotential bonding conductor (PA) and the functional grounding (44), using a first measuring frequency, the measuring impedance having a first impedance value ($Z_{m1}$),
   (c) comparing the first voltage ($U_{PAE1}$) to a voltage threshold
   (d) if the first voltage exceeds the voltage threshold, measuring a second voltage ($U_{PAE2}$) at the alterable measuring impedance, which is switched between the equipotential bonding conductor (PA) and the functional grounding (44), using a second measuring frequency different to the first measuring frequency, the measuring impedance having a second impedance value ($Z_{m2}$) different to the first impedance value ($Z_{m1}$),
   (e) determining a source impedance ($Z_0$) and a source voltage ($U_0$) from the first voltage ($U_{PAE1}$), the second voltage ($U_{PAE2}$), the first impedance value ($Z_{m1}$) and the second impedance value ($Z_{m2}$),
   (f) determining a maximal shock current ($I_{kmax}$) from the source voltage ($U_0$) and the source impedance ($Z_0$),
   (g) testing whether the maximal shock current ($I_{kmax}$) exceeds a shock current threshold and emitting a warning signal when exceeded.

5. A monitoring device for implementing one of the methods according to claims 1 to 4 for monitoring the protection separation of a secondary circuit in a current generator having an equipotential bonding conductor (PA), **characterized by** a functional grounding (44), a alterable measuring impedance (42), which is switched between the equipotential bonding conductor (PA) and the functional grounding (44) and adopts a first impedance value ($Z_{m1}$) or a second impedance value ($Z_{m2}$) different to the first impedance value ($Z_{m1}$),

   a voltage meter (46) for measuring a first and second voltage ($U_{PAE1}$, $U_{PAE2}$) dropping across the alterable measuring impedance (42),
   a computing unit (48) configured for comparing the first voltage ($U_{PAE1}$) to a voltage threshold, for detecting a corresponding phasing of the first and the second voltage ($U_{PAE1}$, $U_{PAE2}$), for determining a source impedance ($Z_0$) and a source voltage ($U_0$), for determining a maximal shock

current ($I_{kmax}$), for testing whether the maximal shock current ($I_{kmax}$) exceeds a shock current threshold and for emitting a warning signal when exceeded.

6. The monitoring device according to claim 5, **characterized in that**
the first impedance value ($Z_{m1}$) is real-valued and has a high impedance and the second impedance value ($Z_{m2}$) is real-valued and smaller than the first impedance value ($Z_{m1}$) and the computing unit (48) is configured for detecting the corresponding phasing of the first voltage ($U_{PAE1}$) and the second voltage ($U_{PAE2}$) with respect to a reference voltage.

7. The monitoring device according to claim 5, **characterized in that**
at least one of the two impedance values ($Z_{m1}$, $Z_{m2}$) is complex-valued and the computing unit (48) is configured in such a manner for detecting the corresponding phasing of the first voltage ($U_{PAE1}$) and the second voltage ($U_{PAE2}$) that the complex-valued impedance value ($Z_{m1}$, $Z_{m2}$) or the complex-valued impedance values ($Z_{m1}$, $Z_{m2}$) are explicitly evaluated.

8. The monitoring device according to claim 5, **characterized in that**
the voltage meter (46) is designed to be frequency-selective.

**Revendications**

1. Procédé pour la surveillance de la séparation de protection d'un circuit secondaire dans un générateur de courant ayant un conducteur de liaison équipotentielle (PA), **caractérisé par** les étapes de procédé :

   (a) appliquer une mise (44) à la terre pour des raisons fonctionnelles aux fins de la sécurité,
   (b) mesurer une première tension ($U_{PAE1}$) à une impédance de mesure (42) changeable intercalée entre le conducteur de liaison équipotentielle (PA) et la mise (44) à la terre pour des raisons fonctionnelles, l'impédance de mesure ayant une première valeur d'impédance ($Z_{m1}$),
   (c) comparer la première tension ($U_{PAE1}$) à un seuil de tension,
   (d) si la première tension ($U_{PAE1}$) dépasse le seuil de tension, mesurer une deuxième tension ($U_{PAE2}$) à l'impédance de mesure changeable intercalée entre le conducteur de liaison équipotentielle (PA) et la mise (44) à la terre pour des raisons fonctionnelles, l'impédance de mesure ayant une deuxième valeur d'impédance ($Z_{m2}$) qui est différente de la première valeur d'impédance ($Z_{m1}$),

   (e) détecter une mise en phase correspondante de la première et de la deuxième tension ($U_{PAE1}$, $U_{PAE2}$),
   (f) déterminer une impédance de source ($Z_0$) et une tension de source ($U_0$) de la première tension ($U_{PAE1}$), de la deuxième tension ($U_{PAE2}$), de la première valeur d'impédance ($Z_{m1}$) et de la deuxième valeur d'impédance ($Z_{m2}$),
   (g) déterminer un courant de choc ($I_{kmax}$) maximal de la tension de source ($U_0$) et de l'impédance de source ($Z_0$),
   (h) tester si le courant de choc ($I_{kmax}$) maximal dépasse un seuil de courant de choc et émettre un signal d'alarme si un dépassement a lieu.

2. Procédé selon la revendication 1, **caractérisé en ce que**
la première valeur d'impédance ($Z_{m1}$) est réelle et à haute impédance et la deuxième valeur d'impédance ($Z_{m2}$) est réelle et est plus inférieure que la valeur d'impédance ($Z_{m1}$), la mise en phase correspondante de la première tension ($U_{PAE1}$) et de la deuxième tension ($U_{PAE2}$) étant détectée par rapport à une tension de référence.

3. Procédé selon la revendication 1, **caractérisé en ce**
**qu'**au moins une de deux valeurs d'impédance ($Z_{m1}$, $Z_{m2}$) est de valeur complexe, la mise en phase correspondante de la première tension ($U_{PAE1}$) et de la deuxième tension ($U_{PAE2}$) étant détectée implicitement en évaluant la valeur d'impédance ($Z_{m1}$, $Z_{m2}$) de valeur complexe ou les valeurs d'impédance ($Z_{m1}$, $Z_{m2}$) de valeur complexe.

4. Un procédé pour la surveillance d'une séparation de protection d'un circuit secondaire dans un générateur de courant ayant un conducteur de liaison équipotentielle (PA), **caractérisé par** les étapes de procédé :

   (a) appliquer une mise (44) à la terre pour des raisons fonctionnelles aux fins de la sécurité,
   (b) mesurer une première tension ($U_{PAE1}$) à une impédance de mesure (42) changeable, qui est intercalée entre le conducteur de liaison équipotentielle (PA) et la mise (44) à la terre pour des raisons fonctionnelles, en utilisant und première fréquence de mesure, l'impédance de mesure ayant une première valeur d'impédance ($Z_{m1}$),
   (c) comparer la première tension ($U_{PAE1}$) à un seuil de tension,
   (d) si la première tension dépasse le seuil de tension, mesurer une deuxième tension ($U_{PAE2}$) à l'impédance de mesure changeable, qui est intercalée entre le conducteur de liaison équipotentielle (PA) et la mise (44) à la terre pour des raisons fonctionnelles, en utilisant une deuxième fréquence de mesure qui est différente de la première fréquence de mesure, l'impédance de mesure ayant une deuxième valeur d'impédance ($Z_{m2}$) qui est différente de la première valeur d'impédance ($Z_{m1}$),

(e) déterminer une impédance de source ($Z_0$) et une tension de source ($U_0$) de la première tension ($U_{PAE1}$), de la deuxième tension ($U_{PAE2}$), de la première valeur d'impédance ($Z_{m1}$) et de la deuxième valeur d'impédance ($Z_{m2}$),

(f) déterminer un courant de choc ($I_{kmax}$) maximal de la tension de source ($U_0$) et de l'impédance de source ($Z_0$),

(g) tester si le courant de choc ($I_{kmax}$) maximal dépasse un seuil de courant de choc et émettre un signal d'alarme si un dépassement a lieu.

5. Dispositif de surveillance pour l'implémentation d'un des procédés selon la revendication 1 à la revendication 4 pour la surveillance de la séparation de protection d'un circuit secondaire dans un générateur de courant ayant un conducteur de liaison équipotentielle (PA), **caractérisé par** une mise (44) à la terre pour des raisons fonctionnelles, une impédance de mesure (42) changeable, qui est intercalée entre le conducteur de liaison équipotentielle (PA) et la mise (44) à la terre pour des raisons fonctionnelles et qui peut adopter une première valeur d'impédance ($Z_{m1}$) ou une deuxième valeur d'impédance ($Z_{m2}$) qui est différente de la première valeur d'impédance ($Z_{m1}$),

un voltmètre (46) pour mesurer une première et deuxième tension ($U_{PAE1}$, $U_{PAE2}$) chutant à travers l'impédance de mesure (42) changeable,

une unité de compte (48) configurée pour comparer la première tension ($U_{PAE1}$) à un seuil de tension, pour détecter une mise en phase correspondante de la première et de la deuxième tension ($U_{PAE1}$, $U_{PAE2}$), pour déterminer une impédance de source ($Z_0$) et une tension de source ($U_0$), pour déterminer un courant de choc ($I_{kmax}$) maximal, pour tester si le courant de choc ($I_{kmax}$) maximal dépasse un seuil de courant de choc et pour émettre un signal d'alarme quand un dépassement a lieu.

6. Dispositif de surveillance selon la revendication 5, **caractérisé en ce que** la première valeur d'impédance ($Z_{m1}$) est réelle et à haute impédance et la deuxième valeur d'impédance ($Z_{m2}$) est réelle et plus inférieure que la première valeur d'impédance ($Z_{m1}$) et l'unité de compte (48) est configurée pour détecter la mise en phase correspondante de la première tension ($U_{PAE1}$) et de la deuxième tension ($U_{PAE2}$) par rapport à une tension de référence.

7. Dispositif de surveillance selon la revendication 5, **caractérisé en ce qu'**au moins une des deux valeurs d'impédance ($Z_{m1}$, $Z_{m2}$) est de valeur complexe et l'unité de compte (48) est configurée pour détecter la mise en phase correspondante de la première tension ($U_{PAE1}$) et de la deuxième tension ($U_{PAE2}$) de telle manière que la valeur d'impédance ($Z_{m1}$, $Z_{m2}$) de valeur complexe ou les valeurs d'impédance ($Z_{m1}$, $Z_{m2}$) de valeur complexe sont évaluées implicitement.

8. Dispositif de surveillance selon la revendication 5, **caractérisé en ce que** le voltmètre (46) est conçu de telle sorte qu'il est sélectif en fréquence.

**Fig. 1**

**Fig. 2**

**Fig. 3**

EP 3 896 463 B1

**Fig. 4**

L1
L2
L3
N

IMD

RCD   RCD   RCD

PA

2
3
6
4
40
42
44
48
$U_{PAE1}, U_{PAE2}$
46
8
$I_K$
$Z_A$
E
7   7   7   7
V

EP 3 896 463 B1

Fig. 5

**Fig. 6b**

**Fig. 6a**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19826410 A1